# EUROPEAN PATENT APPLICATION

(11) **EP 4 814 521 A1**
(43) Date of publication of application: **30.09.2026**
(21) Application number: 26168260.3
(22) Date of filing: 26.03.2026
(51) Int. Cl.: G01R 33/34, G01R 33/3415

(54) **BLANKET-TYPE COIL UNIT AND COIL SYSTEM**

(30) Priority: 28.03.2025 JP 2025056486
(71) Applicant: FUJIFILM Corporation, Tokyo 106-8620 (JP)
(72) Inventor: OTAKE, Yosuke, Tokyo, 1068620 (JP); MATSUMURA, Kiyoshi, Tokyo, 1068620 (JP); ARAI, Koichi, Tokyo, 1068620 (JP); IWASAWA, Kohjiro, Tokyo, 1068620 (JP); OGI, Kazuyuki, Tokyo, 1068620 (JP); KYOTANI, Katsusuke, Tokyo, 1068620 (JP); SASAHARA, Motoki, Tokyo, 1068620 (JP); KATO, Kazuyuki, Tokyo, 1068620 (JP)
(74) Representative: Dehns Germany Partnerschaft mbB

(57) **Abstract**

An aspect of the present invention provides a blanket-type coil unit that can easily match a body shape of a subject (99) and improve closeness between a coil and the subject, and a coil system using the coil unit. A blanket-type coil unit according to an aspect of the present invention is used by being wound around a subject (99) in a case of acquiring a magnetic resonance image, the blanket-type coil unit comprising: at least one first slit (102) provided on at least one side; and fixing members (104, 106) provided on both sides of the first slit (102), in which the fixing members on one side of the first slit are fixed to the fixing members on the other side of the first slit, so that the blanket-type coil unit is deformed into a curved surface (C1, C2) shape in at least a vicinity of the first slit (102).

## Description

### BACKGROUND OF THE INVENTION

### 1. Field of the Invention

The present invention relates to a blanket-type coil unit and a coil system used in a magnetic resonance imaging apparatus.

### 2. Description of the Related Art

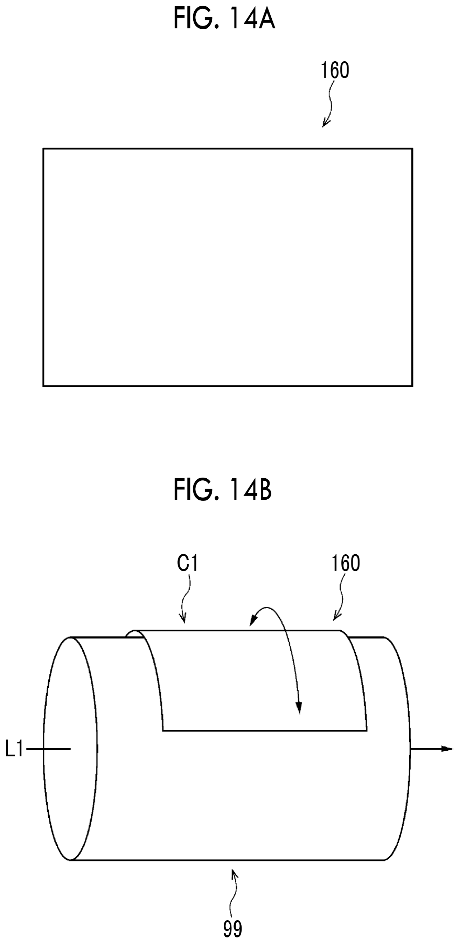

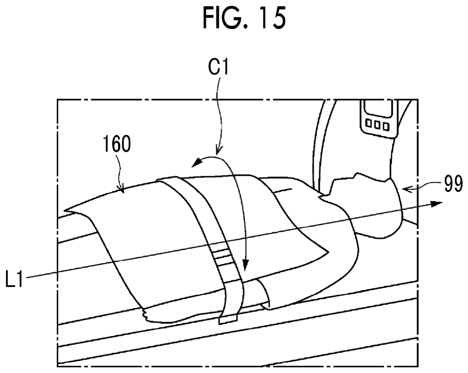

In imaging using a magnetic resonance imaging apparatus (MRI), a rectangular planar shape configured reception coil is known. In order to efficiently acquire a signal from a patient (subject) having a cross section of a substantially circular cylindrical shape or an elliptical cylindrical shape, such a reception coil is wound around an axis along (parallel to) a body axis of the patient and is disposed in a curved surface shape. FIGS. 14A and 14B are schematic views showing a state in which such a reception coil unit of the related art is wound around a subject. FIGS. 14A and 14B show a state in which a rectangular reception coil 160 (for example, an abdominal reception coil) is wound around a subject 99 along a curved surface C1 having a body axis L1 as an axis. Similarly, FIG. 15 shows a state in which the rectangular reception coil 160 is wound around the subject 99 along the curved surface C1 having the body axis L1 as an axis.

In addition, in order to use a coil by winding the coil around a patient one time, a coil assembly in which fixing members (hook-and-loop fasteners) are provided at left and right ends is known (for example, see JP2020-500073A).

### SUMMARY OF THE INVENTION

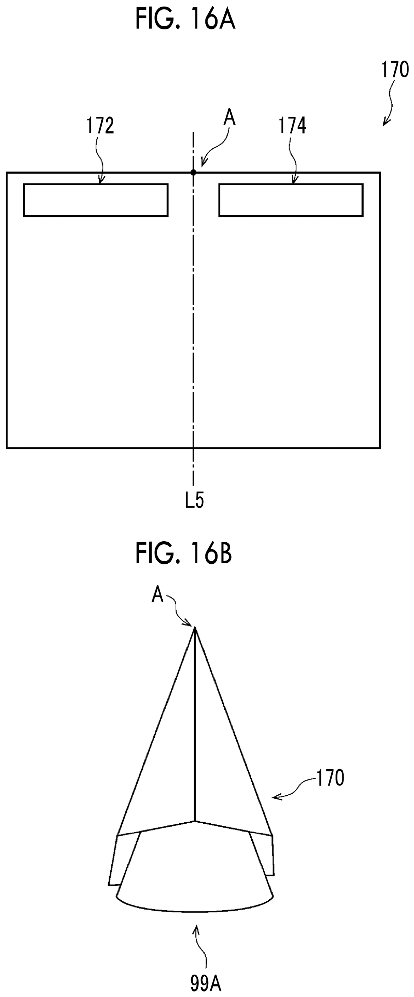

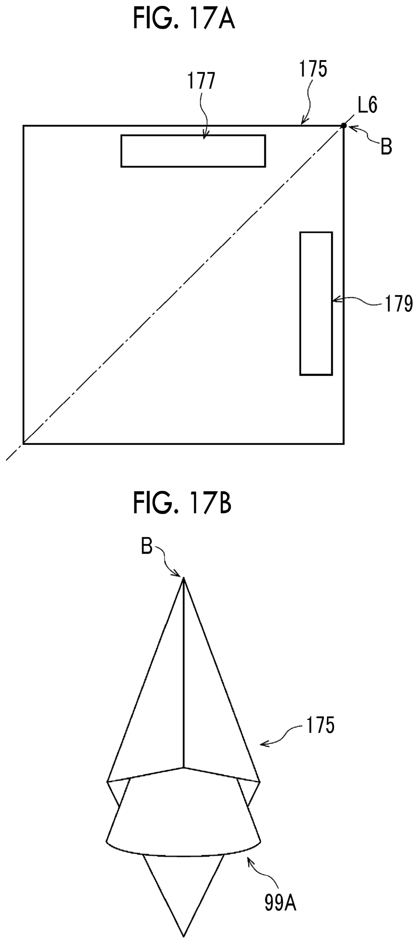

In the coil assembly of JP2020-500073A, since the fixing members are disposed at the left and right ends of the rectangular coil assembly, the coil assembly can be wound around the subject only such that a cross section thereof has a substantially cylindrical shape. In addition, in the rectangular reception coil unit as in the related art, even in a case in which the fixing members are disposed on the same side or adjacent sides and the fixing members are overlapped with each other, only an acute conical shape that hardly exists in the body of the subject can be formed. For example, in a case in which a rectangular reception coil unit 170 shown in FIG. 16A is bent along an axis L5 and fixing members 172 and 174 disposed on the same side are overlapped with each other, an acute conical shape having a point A as an apex is formed with respect to a subject 99A as shown in FIG. 16B. In addition, for example, in a case in which a rectangular (substantially square) reception coil unit 175 shown in FIG. 17B is bent along an axis L6 and fixing members 177 and 179 disposed on adjacent sides are overlapped with each other, an acute conical shape having a point B as an apex is formed with respect to the subject 99A as shown in FIG. 17B.

As described above, in the related art, it is difficult to match the reception coil unit to a body shape of the subject.

The present invention has been made in view of such circumstances, and an object of the present invention is to provide a blanket-type coil unit and a coil system that can easily conform to a body shape of a subject and improve close contact with the subject.

In order to achieve the above-described object, a first aspect of the present invention relates to a blanket-type coil unit used by being wound around a subject in a case of acquiring a magnetic resonance image, the blanket-type coil unit comprising: a first slit provided in at least one side; and fixing members provided on both sides of the first slit, in which, by fixing a fixing member on one side of the first slit to a fixing member on the other side, the blanket-type coil unit is deformed into a curved shape at least in a vicinity of the first slit.

According to the first aspect, since the coil unit is deformed into a curved surface shape in at least the vicinity of the first slit, the coil unit can easily match a body shape of the subject and closeness between the coil unit and the subject can be improved. In a region of the coil unit away from the first slit, a degree of deformation can be made gentler than in the vicinity of the first slit.

In the first aspect and each of the following aspects, a position, a number, a direction, a size (depth of the slit), and the like of the first slit can be appropriately set according to a required degree of deformation.

In embodiments, the blanket-type coil unit is a flexible coil unit that is deformable in a plurality of in-plane directions. The coil unit according to such embodiments can be easily deformed to match a body shape of the subject. The "deformable in a plurality of directions in a plane" is preferably "deformable in all directions in a plane", but does not necessarily have to be "all directions".

In embodiments, the fixing members are sheet-shaped fixing members, and in a case of the fixing members on both sides of the first slit are fixed to each other, the blanket-type coil unit is deformed into different curved surfaces by changing a position at which the fixing members overlap each other. According to such embodiments, it is easy to adjust a degree of deformation of the coil unit to match a body shape of the subject.

In embodiments, a plurality of fixing members are provided on at least one side of the first slit, and the blanket-type coil unit is deformable to different degrees by fixing the blanket-type coil unit using different fixing members among the plurality of fixing members. According to such embodiments, it is easy to adjust a degree of deformation of the coil unit to match a body shape of the subject by using an appropriate one of the plurality of fixing members.

In embodiments, the fixing member on one side of the first slit differs in size and/or shape from the fixing member on the other side. According to such embodiments, a fixing force in a case in which the fixing members are overlapped with each other can be appropriately set.

In embodiments, the first slit includes a changing mechanism with an opening and closing degree, and the blanket-type coil unit is deformed into different curved surfaces by setting to the changing mechanism with different degrees of opening and closing. According to such embodiments, it is easy to set a degree of deformation of the coil unit to match a body shape of the subject.

In embodiments, the fixing members are hook-and-loop fasteners.

In embodiments, the blanket-type coil unit further comprises a second slit provided in a side opposite to the side in which the first slit is provided, in which fixing members are provided on both sides of the second slit, and by fixing a fixing member on one side of the second slit to a fixing member on the other side, the blanket-type coil unit is deformed into a curved shape at least in a vicinity of the second slit. According to such embodiments, by providing the second slit in addition to the first slit, it is easy to adjust a degree of deformation of the coil unit to match a body shape of the subject. The second slit may have the same configuration (size and/or shape of the fixing members, a changing mechanism with an opening and closing degree, the hook-and-loop fastener as the fixing member, and the like) as the first slit.

In embodiments, the first slit and the second slit are provided on the same straight line. The "same straight line" does not have to be "the same" in a mathematically strict sense.

In embodiments, a length of the first slit and a length of the second slit are the same. The "same length" does not have to be the same in a strict sense.

In embodiments, the fixing members are hook-and-loop fasteners.

In embodiments, a groove portion is provided between the first slit and the second slit, and a curved surface having the groove portion as a bottom portion is formed by deformation along the groove portion. As a result, a degree of freedom of the deformation of the coil unit can be increased.

In embodiments, the groove portion is provided in a direction intersecting the first slit and the second slit. The "intersecting direction" is, for example, an orthogonal direction, but does not have to be orthogonal in a strict sense.

In embodiments, a recessed portion is formed on a head side of the subject, in a case where the blanket-type coil unit is wound around the subject. According to such embodiments, it is easy to wind (mount) the blanket-type coil unit around a head portion of the subject.

In embodiments, the first slit and the second slit are provided on a leg side of the subject, relative to a bottom portion of the recessed portion, when the blanket-type coil unit is wound around the subject.

In order to achieve the above-described object, a further aspect of the present invention relates to a coil system comprising: the blanket-type coil unit as defined above; and a fixing assist member for fixing the blanket-type coil unit in a state of being wound around the subject, the fixing assist member being attachable to and detachable from the blanket-type coil unit. According to this aspect, the coil unit can be fixed in a state of being closely attached to the subject by the attachable and detachable fixing assist member (harness).

In embodiments, the blanket-type coil unit includes first fixing members as the fixing members at at least a total of four locations including both end portions in a body-axis direction in a case where the blanket-type coil unit is wound around the subject and both end portions in a direction intersecting the body-axis direction; the fixing assist member includes second fixing members at at least a total of four locations including both end portions in the body-axis direction in a case where the fixing assist member is wound around the subject and both end portions in the direction intersecting the body-axis direction; positions of the second fixing members correspond to positions of the first fixing members; and the blanket-type coil unit and the fixing assist member are fixed to each other by coupling the first fixing members and the second fixing members.

In embodiments, a distance between the second fixing members at both end portions of the fixing assist member in the body-axis direction is shorter than a distance between the first fixing members at both end portions of the blanket-type coil unit in the body-axis direction. According to such embodiments, it is easy to match the coil unit to the body of the subject by pulling the coil unit in with a fixing assist member having a short length.

In embodiments, the first fixing members and the second fixing members are hook-and-loop fasteners.

In embodiments, the fixing assist member is composed of a plurality of fixing assist members, and the plurality of fixing assist members are fixed to each other by third fixing members. The third fixing member may be a hook-and-loop fastener.

As described above, with the blanket-type coil unit and the coil system according to the embodiment of the present invention, it is possible to easily match a body shape of a subject and improve closeness to the subject.

### BRIEF DESCRIPTION OF THE DRAWINGS

FIGS. 1A and 1B are external views of a reception coil unit according to a first embodiment.
FIGS. 2A and 2B are schematic views showing a state in which the reception coil unit is deformed.
FIGS. 3A and 3B are schematic views showing a modification example of the disposition of the fixing member.
FIGS. 4A and 4B are another schematic views showing a modification example of the disposition of the fixing member.
FIG. 5 is still another schematic view showing a modification example of the disposition of the fixing member.
FIGS. 6A and 6B are schematic views showing an example in which a folding line is provided in the reception coil unit.
FIGS. 7A and 7B are views showing a state in which the reception coil unit in which the folding line is provided is deformed.
FIGS. 8A, 8B and 8C are views showing an example of a reception coil unit in which a third slit is provided.
FIGS. 9A, 9B and 9C are views showing an example of a reception coil unit in which a changing mechanism with an opening and closing degree is provided.
FIG. 10 is a view showing an example of a reception coil unit in which a recessed portion is provided on a head side.
FIG. 11 is a view showing a configuration of a coil system according to a second embodiment.
FIG. 12 is a view showing a state in which the coil system is mounted on a subject.
FIG. 13 is a schematic view showing a state in which left and right fixing assist members are integrated.
FIGS. 14A and 14B are views showing a state in which a reception coil unit of the related art is wound around a subject.
FIG. 15 is another view showing a state in which the reception coil unit of the related art is wound around the subject.
FIGS. 16A and 16B are views showing a state in which an acute conical shape is formed by the reception coil unit of the related art.
FIGS. 17A and 17B are another views showing a state in which an acute conical shape is formed by the reception coil unit of the related art.

### DESCRIPTION OF THE PREFERRED EMBODIMENTS

### First embodiment

### Outline Configuration of MRI Apparatus

The reception coil unit according to the first embodiment is used in a case of acquiring a magnetic resonance image in an MRI apparatus (magnetic resonance imaging apparatus). Therefore, first, an example of a schematic configuration of the MRI apparatus will be described. The MRI apparatus comprises an imaging apparatus body, a bed apparatus, a filter box, a control device, and a power supply device. Among these components, the imaging apparatus body and the bed apparatus are installed in a location (an examination room, an imaging room, or the like) shielded with a radio wave shield (and further with a magnetic field shield as necessary), and the control device is installed in a location different from the examination room or the like and communicates with the filter box.

The imaging apparatus main body 100 comprises a static magnetic field generation source 102, a gradient magnetic field coil 104, and an irradiation coil 106. The imaging apparatus main body 100 may be a bore-type apparatus having a tunnel-shaped or cylindrical-shaped imaging space, or may be an open-type apparatus having an open imaging space. The static magnetic field generation source is a magnet that generates a uniform static magnetic field in a static magnetic field space that accommodates the subject, and the gradient magnetic field coil is a coil that generates a gradient magnetic field superimposed on the static magnetic field space. The static magnetic field generation source 102 may be configured of a superconducting magnet (superconducting coil) or may be configured of a normal conductive magnet. The irradiation coil 106 is a coil for irradiating the subject 99 with an RF pulse in order to cause nuclear magnetic resonance to occur in nuclear spins of atoms constituting a biological tissue of the subject 99.

The subject is placed on a top plate of the bed apparatus, and the top plate is moved to carry the subject into the imaging space and to carry the subject out of the imaging space. The bed apparatus may be an apparatus in which a height can be changed. In addition, the bed apparatus may be fixed to the imaging apparatus body or may be attachable and detachable. The filter box 300A is provided between an examination room or the like in which the imaging apparatus main body 100 and the bed device 200 are installed and the control device 400, and cables connected to the imaging apparatus main body 100 and the bed device 200 are connected to the control device 400 via the filter box 300A. The control device comprises a processor, a memory such as a read only memory (ROM) or a random access memory (RAM), and various recording devices, display devices, and the like, and can reconstruct a magnetic resonance image of the subject by using a signal received by the reception coil unit and can display, record, and the like the image as necessary.

### Examples of Reception Coil Unit

Hereinafter, examples of the reception coil unit according to the first embodiment will be described with reference to the accompanying drawings. In the accompanying drawings, for convenience of description, some members or imaginary lines may be omitted. In addition, the accompanying drawings do not accurately show a shape or a size of the reception coil unit according to the present invention.

### Example 1

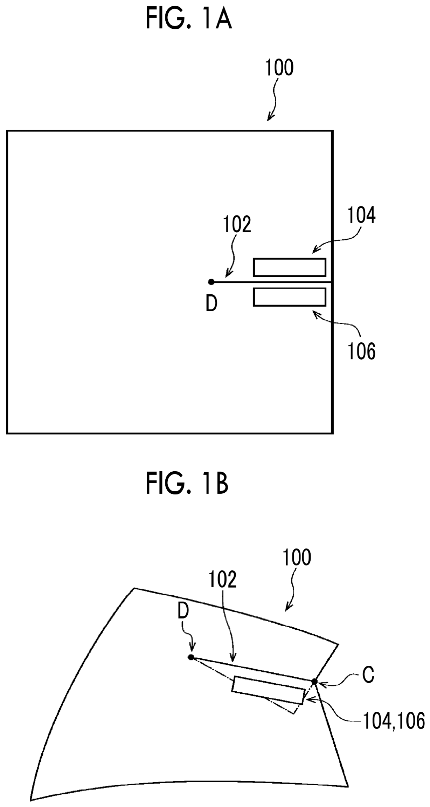

FIGS. 1A and 1B are external views of a reception coil unit 100 (blanket-type coil unit) according to Example 1. The reception coil unit 100 is a flexible blanket-type coil unit that is used by being wound around a subject in a case of acquiring a magnetic resonance image, and is configured as a unit comprising, for example, a plurality of reception coil elements (element coils) formed in a loop shape and disposed in a two-dimensional array shape, and receives a signal from the subject. The reception coil unit 100 is preferably a flexible coil unit that can be deformed in a plurality of directions in a plane, and it is more preferable that the flexible coil unit can be deformed in all directions in the plane. The signal received by each element is transmitted to the control device through a connector (not shown) and is used for generating the magnetic resonance image. The signal may be transmitted and received through a wireless transceiver antenna.

FIG. 1A is a front view of the reception coil unit 100. As shown in FIG. 1A, the reception coil unit 100 has a substantially rectangular shape, and a first slit 102 (first slit) is provided on at least one side (a right side in FIG. 1A) of the reception coil unit 100. A point at the back of the first slit 102 is denoted by D.

In addition, the reception coil unit 100 is provided with fixing members 104 and 106 (fixing members) on both sides of the first slit 102, and the fixing member on one side of the first slit 102 (one of the fixing member 104 or the fixing member 106) is fixed to the fixing member on the other side of the first slit 102 (the other of the fixing member 104 or the fixing member 106), so that the reception coil unit 100 is deformed into a curved surface shape in at least a vicinity of the first slit 102 as shown in FIG. 1B (external perspective view showing a fixed state; state in which the reception coil unit 100 is viewed from an oblique upward direction). Specifically, a gentle curved surface such as a cone having the point D as an apex is formed.

As shown in FIG. 1B, the sides of the reception coil unit 100 intersect each other by overlapping the regions on both sides of the first slit 102, and a line having the point D as an apex and the point C as a bottom point is formed. The same applies to the points C and D in the following examples.

As described above, the reception coil unit 100 of Example 1 can be gently deformed unlike the acute conical shape described above with reference to FIGS. 16A to 17B, and can easily match a body shape of the subject (particularly, a protruding surface such as a breast, a knee, an elbow, and a shoulder) and improve closeness to the subject.

In the reception coil unit 100, conditions such as the number of first slits 102, a position (vertical position in FIGS. 1A and 1B) and a direction of the first slit 102, and a length of the slit may be different according to a required curved surface shape or a degree of deformation. In addition, even in a case in which these conditions are the same, the reception coil unit 100 can be deformed into different curved surfaces by changing a position at which the fixing members are overlapped with each other (changing a size of the overlap).

In the reception coil unit 100, a hook-and-loop fastener, a button, an adjuster (for example, one of the fixing member 104 and the fixing member 106 has a hole and the other has a protrusion corresponding to the hole), or the like can be used as the fixing members 104 and 106. It is preferable that these fixing members are formed of a non-magnetic material. It is assumed that the fixing members 104 and 106 are attached to a surface in consideration of the overlapping on both sides of the first slit 102. For example, in a case in which the fixing members 104 and 106 are hook-and-loop fasteners, the fixing member 104 may be disposed on a front surface of the reception coil unit 100 and the fixing member 106 may be disposed on a back surface, or the reverse may be true. In addition, the fixing members 104 and 106 may be disposed on both the front surface and the back surface, and may be configured such that either one may be on an upper side in a case of overlapping. These aspects related to the disposition of the fixing members can also be applied to the following examples.

### Modification Example of Disposition of Fixing Member

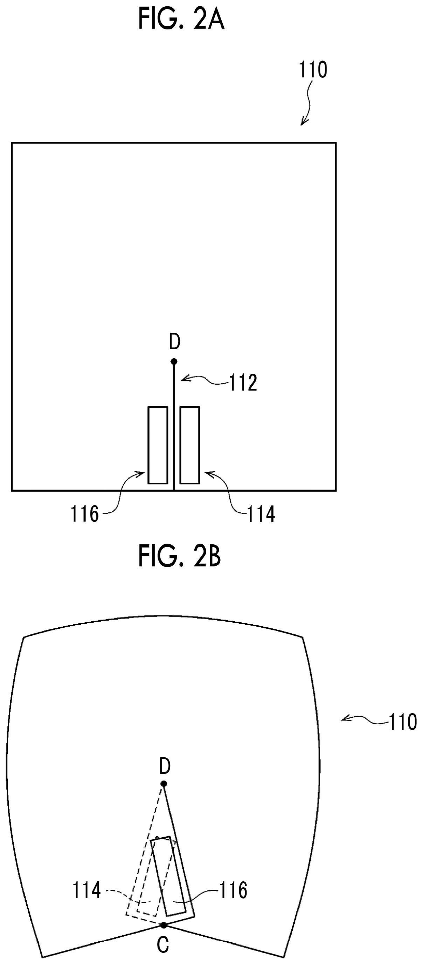

FIGS. 2A and 2B are schematic views for describing disposition conditions (number, position, size, shape, and the like) of the fixing members. FIG. 2A is a front view of a reception coil unit 110. As shown in FIG. 2A, the reception coil unit 110 is provided with a first slit 112 (the back is the point D) as in the reception coil unit 100 described above, and fixing members 114 and 116 are provided on both sides of the first slit 112. In a case in which the reception coil unit 110 is fixed by the fixing member 114 and the fixing member 116, in a case in which these fixing members are linear or are long and narrow planar, the region in which the fixing members overlap with each other may be small and the fixing force may be weakened as shown in FIG. 2B depending on a size of an overlapping portion.

### Example of Disposing Fixing Member at an Angle

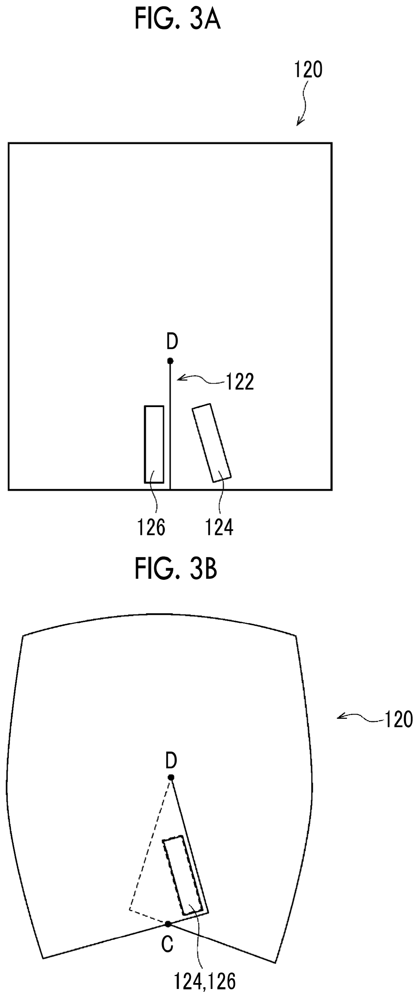

Therefore, for example, as in a reception coil unit 120 shown in FIG. 3A, by disposing one fixing member (in this example, the fixing member 124) at an angle with respect to the other fixing member (in this example, the fixing member 126), the fixing members can be made to perfectly overlap with each other in a case of overlapping as shown in FIG. 3B. In the example of FIGS. 3A and 3B, the fixing member 124 is disposed away from the slit 122 with respect to the fixing member 126.

The degree to which one fixing member is inclined with respect to the other fixing member or the degree to which one fixing member is disposed away from the slit can be determined according to the degree of the overlapping (that is, the required degree of deformation). Both fixing members may be inclined with respect to the slit, and in this case, for example, the fixing member 126 can be disposed symmetrically with respect to the fixing member 124 in the state shown in FIG. 3A with respect to the slit 122. With such disposition, a portion in which the fixing members overlap with each other can be widened, and the fixing force can be increased.

### Example of Changing Size and Direction of Fixing Member

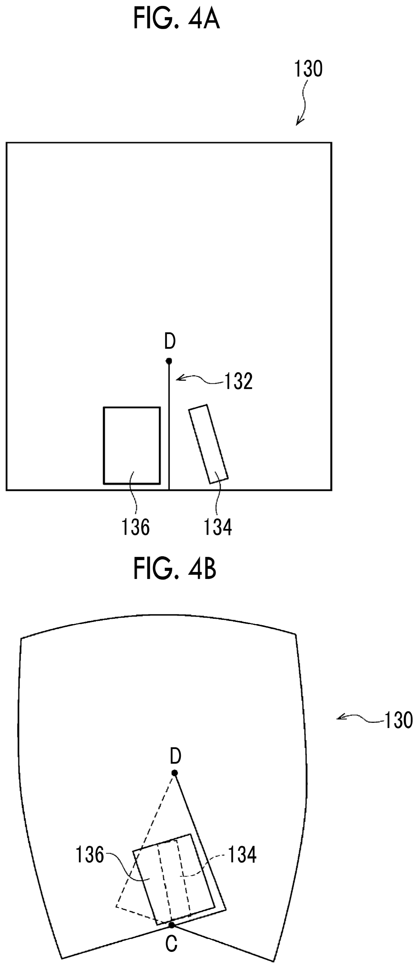

In addition, the size may be changed between one fixing member and the other fixing member. For example, as in a reception coil unit 130 (in which a slit 132 is formed and the back is the point D) shown in FIG. 4A, the size and the direction can be changed between a fixing member 134 and a fixing member 136. In this case, a state in which both sides of the slit 132 are overlapped is as shown in FIG. 4B, and the fixing member 134 can be made to completely overlap with the fixing member 136 even in a case in which the overlapping method is slightly changed.

### Example of Providing Plurality of Fixing Members

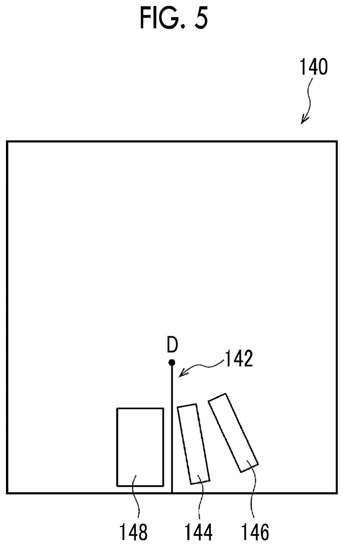

In addition, a plurality of fixing members may be provided on at least one side of the slit. For example, as in a reception coil unit 140 shown in FIG. 5, the fixing members 144 and 166 can be provided (inclined with respect to the slit 142) on one side (right side in FIG. 5) of a slit 142 (the back is the point D), and the fixing member 148 can be provided on the other side. The fixing member 148 is larger than the fixing members 144 and 166.

### Formation of Second Slit and Folding Line

In the above-described example, an example in which the first slit is provided on one side is shown, but in the reception coil unit according to the embodiment of the present invention, a second slit may be provided on a side facing the first slit. As described above for the first slit, the fixing members can be provided on both sides of the second slit, and the fixing member on one side of the second slit can be fixed to the fixing member on the other side of the second slit, so that the reception coil unit is deformed into a curved surface shape in at least a vicinity of the second slit.

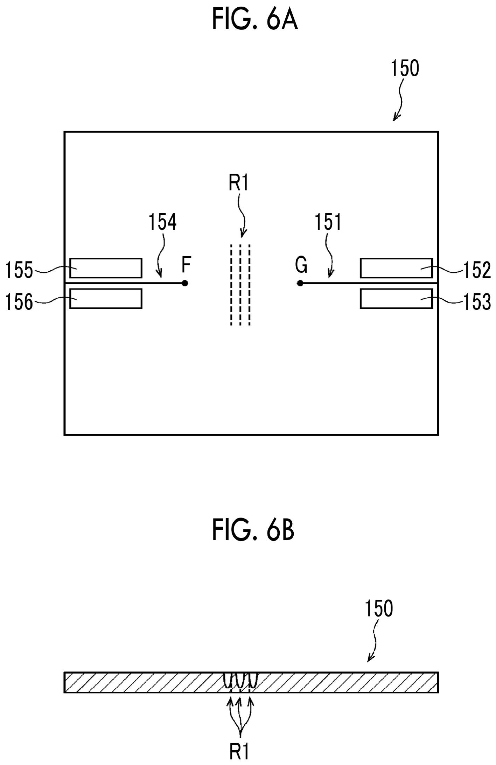

FIGS. 6A and 6B are views showing an example of a reception coil unit in which the first slit and the second slit are provided. As shown in FIG. 6A (front view of a reception coil unit 150), the first slit 151 (first slit) and the second slit 154 (second slit) are provided on facing sides (left and right sides in FIG. 6) of the reception coil unit 150, and the fixing members 152 and 153 are provided on both sides of the first slit 151, and the fixing members 155 and 156 are provided on both sides of the second slit 154. The first slit 151 and the second slit 154 can be provided on the same straight line. In addition, as in the above-described example, a point at the back of the first slit 151 is denoted by G, and a point on the back side of the second slit 154 is denoted by F.

The reception coil unit 150 having the above-described configuration is deformed into a curved surface shape in at least a vicinity of the first slit 151 by fixing the fixing member 152 and the fixing member 153, and is deformed into a curved surface shape in at least a vicinity of the second slit 154 by fixing the fixing member 155 and the fixing member 156. As a result, it is easy to match the reception coil unit 150 to a body shape of the subject, and closeness to the subject can be improved.

In the reception coil unit 150 having the above-described configuration, the above-described aspects can be appropriately adopted for the positions, the number, and the directions of the first and second slits and the positions, the number, the shapes, and the sizes of the first and second fixing members.

### Formation of Fold Line

In addition, a folding line R1 (groove portion) is provided in the reception coil unit 150 in a direction orthogonal (an example of intersection) to the first slit 151 and the second slit 154 between the first slit 151 and the second slit 154 (see cross-sectional views of FIGS. 6A and 6B). It is preferable that the folding line R1 is formed to be parallel to a body axis direction of the subject in a case in which the reception coil unit 150 is wound around the subject. An example of the folding line is a groove shown in FIG. 6B, and is disposed at a position that is a valley in a case of folding. The groove portion can have a shape that is wide on an upper side of the drawing and narrow on a lower side of the drawing, such as a V-shape, a U-shape, a semicircular shape, and a semi-elliptical shape. In addition, the number and the length of the folding lines R1 may be changed according to the amount of deformation or the shape to be deformed.

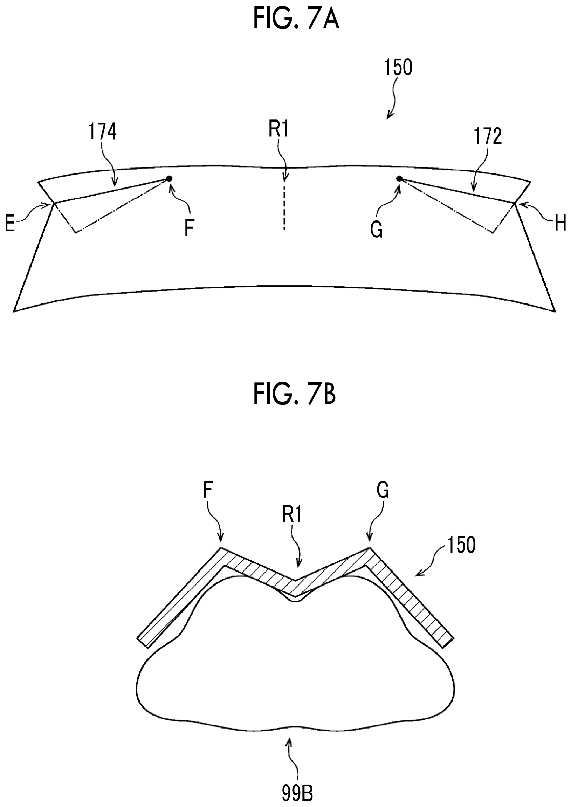

FIGS. 7A and 7B are views showing a state in which the reception coil unit 150 shown in FIG. 6 is deformed by overlapping the fixing members on both sides of the first slit 151 and the second slit 154. As shown in the perspective view shown in FIG. 7A, the reception coil unit 150 is deformed into a curved surface shape in the vicinity of a line (formed by overlapping the first slit 172 portion) connecting the point G and the point H and in the vicinity of a line (formed by overlapping the second slit 174 portion) connecting the point F and the point E. The reception coil unit 150 is further deformed along the folding line R1 (groove portion) described above, and a curved surface having the folding line R1 as a bottom portion is formed.

FIG. 7B is a view (cross-sectional view) showing a state in which the reception coil unit 150 in the deformed state is wound around a subject 99B. In the deformed state, the point F and the point G are apexes and the folding line R1 is a bottom portion, so that it is easy to deform along the breast of the subject 99B, and closeness can be improved. The same applies to other protruding surfaces other than the breast.

### Formation of Third Slit

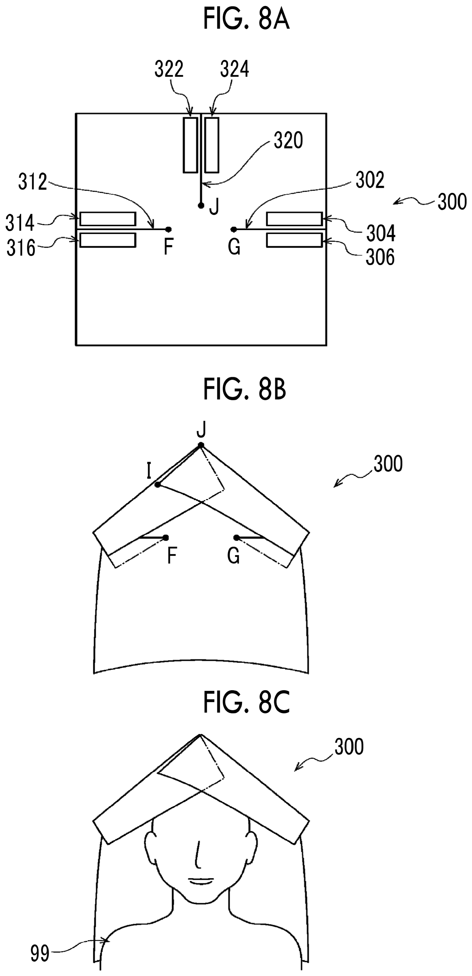

In the reception coil unit according to the embodiment of the present invention, a third slit may be provided in addition to the first and second slits. For example, in a reception coil unit 300 shown in FIG. 8A, a first slit 302 and a second slit 312 are provided on facing sides (in the left-right direction in the drawing), and a third slit 320 is provided on a side (upper side in the drawing) adjacent to the side on which the first and second slits are provided. The fixing members 304 and 306 are provided on both sides of the first slit 302, the fixing members 314 and 316 are provided on both sides of the second slit 312, and the fixing members 322 and 324 are provided on both sides of the third slit 320. The first slit 302 and the second slit 312 may be provided on the same straight line. A point on the back side and a point on the outer side of the first slit 302 are denoted by G and H, respectively, a point on the back side and a point on the outer side of the second slit 312 are denoted by F and E, respectively, and a point on the back side and a point on the outer side of the third slit 320 are denoted by J and I, respectively.

In a case in which the fixing members on both sides of the first to third slits of the reception coil unit 300 are overlapped with each other and fixed, the reception coil unit 300 is deformed into a shape having the point J as an apex as shown in FIG. 8B, and thus can be placed on the head of the subject 99 as shown in FIG. 8C and can be used for imaging the head. In FIGS. 8B and 8C, the fixing members and some imaginary lines are not shown.

### Opening and Closing Degree Changing Mechanism of Slit

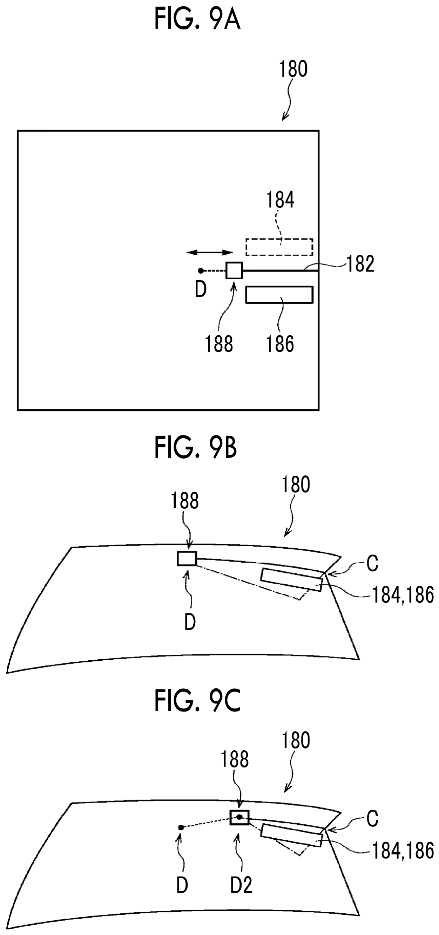

FIGS. 9A, 9B and 9C are views showing an example of a reception coil unit in which an opening and closing degree changing mechanism of a slit is provided. As shown in FIG. 9A (front view), a first slit 182 (the back is the point D) is provided in a reception coil unit 180, and fixing members 184 and 186 are provided on both sides of the first slit 182. In addition, a slit opening and closing member 188 (a changing mechanism with an opening and closing degree) is provided in the first slit 182.

The reception coil unit 180 can change the opening and closing degree of the first slit 182 by moving the slit opening and closing member 188 along the first slit 182. For example, FIG. 9B shows a state in which the slit opening and closing member 188 is present at the back (point D) of the first slit 182, and in this state, the point D is an apex of the curved surface. On the other hand, FIG. 9C shows a state in which the slit opening and closing member 188 is present at the middle (point D2) of the first slit 182, and in this state, the point D2 is an apex of the curved surface. As described above, the reception coil unit 180 can set the first slit 182 to different opening and closing degrees by the slit opening and closing mechanism, and thus can change the position of the apex of the curved surface and be deformed into different curved surfaces, so that it is easy to deform along the body shape of the subject and closeness to the subject can be improved.

The above-described configuration can be appropriately adopted in the reception coil unit according to another aspect, and can be applied in the same manner even in a case in which the reception coil unit comprises a second slit or a third slit (see FIGS. 6, 8, and 10). As shown in FIGS. 9B and 9C, since the shape of the entire curved surface changes in a case in which the position of the apex is changed, it is preferable that the user overlaps the fixing members 184 and 186 again to match the entire reception coil unit 180 to the body shape of the subject in accordance with the change in the position of the apex.

The first slit 182 and the slit opening and closing member 188 described above can be realized by a slide fastener, a zip fastener, a button, or the like.

### Aspect of Providing Recessed portion

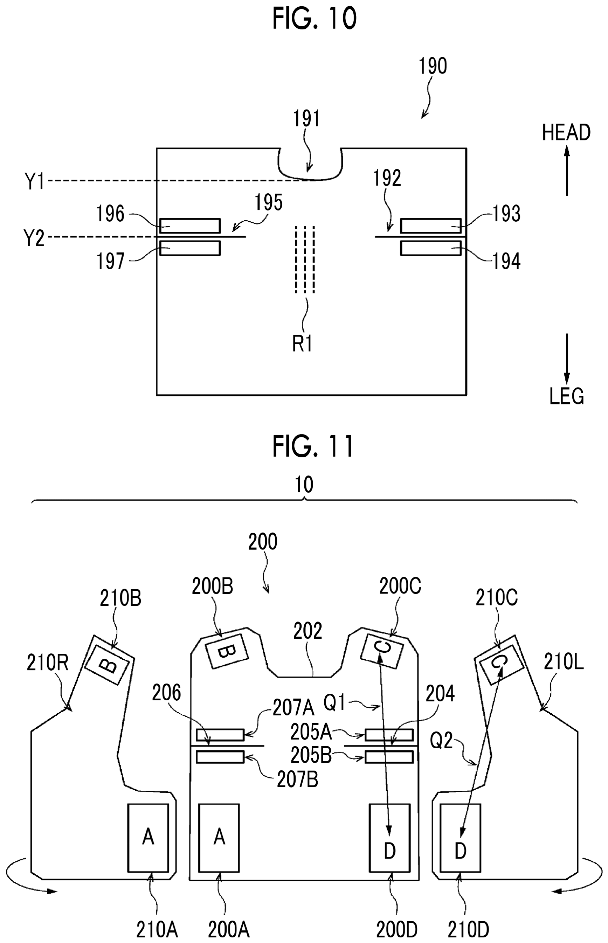

In each aspect of the reception coil unit according to the embodiment of the present invention, a recessed portion may be formed on a head side of the subject in a case in which the coil unit is wound around the subject. For example, in a reception coil unit 190 shown in FIG. 10, a recessed portion 191 is provided at an upper portion (head side of the subject) of the drawing, and thus it is easy to wind (mount) the reception coil unit around a head portion of the subject. In the reception coil unit 190, the first slit 192 and the second slit 195 are provided on a leg side (body axis direction position: Y2) in a case in which the reception coil unit 190 is wound around the subject, with respect to a bottom portion (body axis direction position: Y1) of the recessed portion 191. It is preferable that the first slit 192 and the second slit 195 are provided on the same straight line with the same length, but they do not have to be on the same straight line or have the same length in a strict sense.

As in the other aspects, in the reception coil unit 190, fixing members 193 and 194 are provided on both sides of the first slit 192, and fixing members 196 and 197 are provided on both sides of the second slit 195, and the reception coil unit 190 is deformed into a curved surface shape in at least a vicinity of the first slit 192 and a vicinity of the second slit 195 by these fixing members. A slit opening and closing mechanism may be provided in the first slit 192 and/or the second slit 195. In addition, the reception coil unit 190 is provided with a folding line R1 as in the reception coil unit 150 described above.

### Second Embodiment

In the first embodiment, the reception coil unit as one aspect of the present invention has been described, but the other aspect of the present invention provides a coil system comprising a reception coil unit and a fixing assist member (fixing assist member, harness). Hereinafter, the coil system according to this aspect will be described.

### Configuration of Coil System

FIG. 11 is a diagram showing a configuration of a coil system 10 (coil system) according to the second embodiment. As shown in FIG. 11, the coil system 10 comprises a reception coil unit 200 (blanket-type coil unit), a left fixing assist member 210L (fixing assist member), and a right fixing assist member 210R (fixing assist member). The left fixing assist member 210L and the right fixing assist member 210R constitute a plurality of fixing assist members. A fixing member (third fixing member) that fixes the left fixing assist member 210L and the right fixing assist member 210R may be provided. In the reception coil unit 130, a first slit 204 and a second slit 206 are formed at positions facing each other on the left-right direction side of FIG. 11 (on the same straight line), and as in each of the above-described aspects, fixing members 205A and 205B are provided on both sides of the first slit 204, and fixing members 207A and 207B are provided on both sides of the second slit 206. In addition, a recessed portion 202 is formed in the reception coil unit 200. Instead of such a reception coil unit 200, the reception coil unit according to each example and modification example of the first embodiment may be used.

The left fixing assist member 210L and the right fixing assist member 210R are fixing assist members (harnesses) for fixing the reception coil unit 200 in a state of being wound around the subject, and are attachable to and detachable from the reception coil unit 200. These fixing assist members may be formed of a mesh material. In FIG. 11, a fixing assist member positioned on a left side of the subject in a case of being wound around the subject is denoted by the left fixing assist member 210L, and a fixing assist member positioned on a right side of the subject is denoted by the right fixing assist member 210R. In FIG. 11, the fixing assist members are displayed in reverse front and back in order to clarify the correspondence between the fixing member of the fixing assist member and the fixing member of the reception coil unit 200.

### Fixing of Reception Coil Unit and fixing assist member by Fixing Member

In the coil system 10 described above, the fixing members are provided in the reception coil unit 200, the left fixing assist member 210L, and the right fixing assist member 210R, and the reception coil unit 200, the left fixing assist member 210L, and the right fixing assist member 210R are fixed to each other by bonding these fixing members to each other. In the reception coil unit 200, first fixing members 200A to 200D (first fixing members) are provided at at least four locations (both shoulder portions and both flanks in a case of being wound around the subject) of both end portions in the body axis L1 direction and both end portions in a direction orthogonal to the body axis L1 direction. The "both end portions" does not have to be the both end portions in a strict sense.

On the other hand, in the left fixing assist member 210L, second fixing members 210C and 210D (second fixing members) are provided at both end portions in the body axis L1 direction in a case of being wound around the subject, and in the right fixing assist member 210R, second fixing members 210A and 210B (second fixing members) are provided at both end portions in the body axis L1 direction in a case of being wound around the subject. The positions of the second fixing members are two positions on each of the left and right fixing assist members, for a total of four positions, and these second fixing members are provided at positions corresponding to the positions of the first fixing members. The number of second fixing members (total of four positions) is counted for both the left and right fixing assist members.

In the reception coil unit 200, in a case in which a distance between the first fixing members at both end portions in the body axis direction (center-to-center distance between the first fixing members 200C and 200D) is denoted by a distance Q1, and in a case in which a distance between the second fixing members at both end portions in the body axis direction (center-to-center distance between the second fixing members 210C and 210D) in the left fixing assist member 210L and the right fixing assist member 210R is denoted by a distance Q2, the distance Q2 is shorter than the distance Q1 (distance Q2 < distance Q1). As a result, the reception coil unit 200 can be pulled in by the left fixing assist member 210L and the right fixing assist member 210R having a short body axis direction length, and closeness to the subject can be improved. The relationship between the distances between such fixing members is the same for a center-to-center distance between the first fixing members 200A and 200B and a center-to-center distance between the second fixing members 210A and 210B.

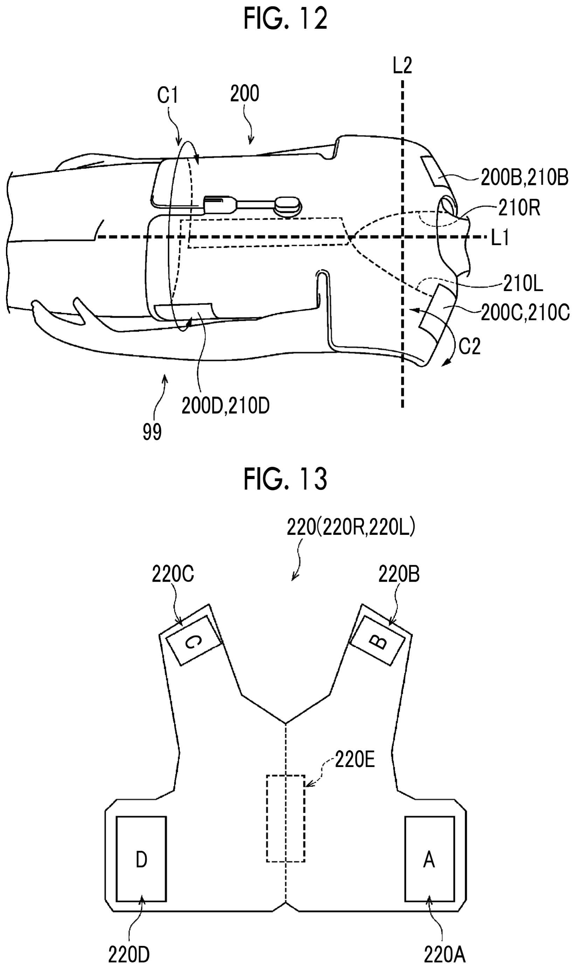

FIG. 12 is a view showing a state in which the coil system 10 is mounted on the subject 99. In the coil system 10 according to the second embodiment, with the above-described configuration, the reception coil unit 200 can be deformed along an abdominal region (region on the leg side; curved surface C1 having the body axis L1 as an axis) and a shoulder region (region on the head side; curved surface C2 having the second axis L2 as an axis) of the body shape of the subject 99, and closeness between the reception coil unit 200 and the subject 99 can be improved. FIG. 12 shows a state in which the fixing members (not shown) are not overlapped with each other, but the reception coil unit 200 may be deformed as in the example shown in FIGS. 7A and 7B by overlapping and fixing the fixing members on both sides of the first slit 204 and the second slit 206. As described above, the user can select a state in which the fixing is not performed by the fixing member (state of FIG. 11) and a state in which the fixing is performed (state of FIGS. 7A and 7B), and can deform the coil system 10 into an appropriate shape according to conditions such as the purpose of the examination, the target part, and the body shape of the subject.

In the coil system 10, a hook-and-loop fastener, a button, an adjuster (one of the first fixing member and the second fixing member has a hole and the other has a protrusion corresponding to the hole), or the like can be used as the first fixing members 200A to 200D and the second fixing members 210A to 210D. The shape, the size, the disposition, and the number of these fixing members may be appropriately changed, and it is preferable that the closeness of the reception coil unit 200 to the subject 99 can be adjusted by changing these conditions.

FIG. 13 is a view showing a state in which the fixing assist members are integrated. A fixing assist member 220 (fixing assist member, harness) shown in FIG. 13 is configured by integrating the left and right fixing assist members, and as in the left fixing assist member 210L and the right fixing assist member 210R described above, second fixing members 220A to 220D (second fixing members) are provided at at least four locations of both end portions in the body axis L1 direction and both end portions in a direction orthogonal to the body axis L1 direction in a case of being wound around the subject. The second fixing members 220A to 220D are provided at positions corresponding to the first fixing members 200A to 200D of the reception coil unit 200 (the relationship between the distances between the fixing members is also the same as described above), and thus the reception coil unit 200 can be closely attached to the subject 99 even in a case in which the integral-type fixing assist member 220 is used. As in the first fixing members 200A to 200D and the second fixing members 210A to 210D described above, a hook-and-loop fastener, a button, an adjuster, or the like can be used as the second fixing members 220A to 220D.

Although the integral-type fixing assist member 220 is shown in FIG. 13, in a case in which the fixing assist member 220 is separated and formed as two fixing assist members (separated in the vertical direction of FIG. 13 at the center in the left-right direction of the fixing assist member 220; body axis L1 direction), the fixing assist member 220L and the fixing assist member 220R (a plurality of fixing assist members) are obtained. In this case, a fixing member 220E (hook-and-loop fastener, button, adjuster, or the like; third fixing member) for bonding the left fixing assist member 220L and the right fixing assist member 220R and using them as an integral member may be provided.

Although the embodiments, examples, and modification examples of the present invention have been described above, the present invention is not limited to the above-described aspects, and various modifications are possible, provided they fall within the scope of the invention as defined by the claims.

### Explanation of References

10: coil system
99: subject
99, 99A: subject
99B: subject
100: reception coil unit
102: first slit
104: fixing member
106: fixing member
110: reception coil unit
112: first slit
114: fixing member
116: fixing member
120: reception coil unit
122: slit
124: fixing member
126: fixing member
130: reception coil unit
132: slit
134: fixing member
136: fixing member
140: reception coil unit
142: slit
144: fixing member
148: fixing member
150: reception coil unit
151: first slit
152: fixing member
153: fixing member
154: second slit
155: fixing member
156: fixing member
160: reception coil
166: fixing member
170: reception coil unit
172: fixing member
174: fixing member
175: reception coil unit
177: fixing member
179: fixing member
180: reception coil unit
182: first slit
184: fixing member
186: fixing member
188: slit opening and closing member
190: reception coil unit
191: recessed portion
192: first slit
193: fixing member
194: fixing member
195: second slit
196: fixing member
197: fixing member
200: reception coil unit
200A: first fixing member
200B: first fixing member
200C: first fixing member
200D: first fixing member
202: recessed portion
204: first slit
205A: fixing member
205B: fixing member
206: second slit
207A: fixing member
207B: fixing member
210A: second fixing member
210B: second fixing member
210C: second fixing member
210D: second fixing member
210L: left fixing assist member
210R: right fixing assist member
220: fixing assist member
220A: second fixing member
220B: second fixing member
220C: second fixing member
220D: second fixing member
220E: fixing member
220L: left fixing assist member
220R: right fixing assist member
300: reception coil unit
302: first slit
304: fixing member
306: fixing member
312: second slit
314: fixing member
316: fixing member
320: first slit
322: fixing member
324: fixing member
C1: curved surface
C2: curved surface

## Claims

1. A blanket-type coil unit used by being wound around a subject (99) in a case of acquiring a magnetic resonance image, the blanket-type coil unit comprising:
a first slit (102, 122) provided in at least one edge; and
fixing members (104, 106, 114, 116) provided on both sides of the first slit,
wherein, by fixing a fixing member on one side of the first slit to a fixing member on the other side, the blanket-type coil unit is deformed into a curved shape at least in a vicinity of the first slit.

2. The blanket-type coil unit according to claim 1,
wherein the blanket-type coil unit is a flexible coil unit that is deformable in a plurality of in-plane directions.

3. The blanket-type coil unit according to claim 1 or 2,
wherein the fixing members (104, 106, 114, 116) are sheet-shaped fixing members, and
in a case where the fixing members on both sides of the first slit (102, 112) are fixed to each other, the blanket-type coil unit is deformed into different curved surfaces by changing a position at which the fixing members overlap each other.

4. The blanket-type coil unit according to any one of claims 1 to 3,
wherein a plurality of fixing members (144, 146) are provided on at least one side of the first slit (142), and
the blanket-type coil unit is deformable to different degrees by fixing the blanket-type coil unit using different fixing members among the plurality of fixing members.

5. The blanket-type coil unit according to any one of claims 1 to 4,
wherein the fixing member (148) on one side of the first slit (142) differs in size and/or shape from the fixing member (144, 146) on the other side.

6. The blanket-type coil unit according to any one of claims 1 to 5,
wherein the first slit (142) includes a changing mechanism with an opening and closing degree, and the blanket-type coil unit is deformed into different curved surfaces by setting the changing mechanism to different degrees of opening and closing.

7. The blanket-type coil unit according to any one of claims 1 to 6,
wherein the fixing members are hook-and-loop fasteners.

8. The blanket-type coil unit according to any one of claims 1 to 7, further comprising:
a second slit (154) provided in an edge opposite to the side in which the first slit (151) is provided,
wherein fixing members (155, 156) are provided on both sides of the second slit, and
by fixing a fixing member on one side of the second slit to a fixing member on the other side, the blanket-type coil unit is deformed into a curved shape at least in a vicinity of the second slit.

9. The blanket-type coil unit according to claim 8,
wherein the first slit (151) and the second slit (154) are provided on the same straight line.

10. The blanket-type coil unit according to claim 8 or 9,
wherein a length of the first slit (151) and a length of the second slit (154) are the same.

11. The blanket-type coil unit according to any one of claims 8 to 10,
wherein the fixing members are hook-and-loop fasteners.

12. The blanket-type coil unit according to any one of claims 8 to 11,
wherein a groove portion is provided between the first slit (151) and the second slit (154), and a curved surface having the groove portion as a bottom portion is formed by deformation along the groove portion, and
preferably, the groove portion is provided in a direction intersecting the first slit and the second slit.

13. The blanket-type coil unit according to any one of claims 8 to 12,
wherein a recessed portion (191) is formed on a head side of the subject (99), in a case where the blanket-type coil unit is wound around the subject, and
preferably, the first slit (192) and the second slit (195) are provided on a leg side of the subject, in a case where the blanket-type coil unit is wound around the subject, relative to a bottom portion of the recessed portion.

14. A coil system comprising:
the blanket-type coil unit according to any one of claims 1 to 13; and
a fixing assist member (220) for fixing the blanket-type coil unit in a state of being wound around the subject, the fixing assist member being attachable to and detachable from the blanket-type coil unit.

15. The coil system according to claim 14,
wherein the blanket-type coil unit includes first fixing members (200A, 200B, 200C, 200D) as the fixing members at at least a total of four locations including both end portions in a body-axis direction in a case where the blanket-type coil unit is wound around the subject and both end portions in a direction intersecting the body-axis direction;
the fixing assist member (220) includes second fixing members (220A, 220B, 220C, 220D) at at least a total of four locations including both end portions in the body-axis direction in a case where the fixing assist member is wound around the subject and both end portions in the direction intersecting the body-axis direction;
positions of the second fixing members correspond to positions of the first fixing members; and
the blanket-type coil unit and the fixing assist member are fixed to each other by coupling the first fixing members and the second fixing members, and
preferably, a distance between the second fixing members at both end portions of the fixing assist member in the body-axis direction is shorter than a distance between the first fixing members at both end portions of the blanket-type coil unit in the body-axis direction.
